# EUROPÄISCHE PATENTSCHRIFT

(11) **EP 3 084 897 B1**
(45) Veröffentlichungstag und Bekanntmachung des Hinweises auf die Patenterteilung: **08.01.2020**
(21) Anmeldenummer: 14793580.3
(22) Anmeldetag: 06.11.2014
(51) Int. Cl.: H01R 13/52, H01R 9/22

(54) **ELEKTRISCHE BAUGRUPPE**
ELECTRICAL ASSEMBLY
SOUS-ENSEMBLE ÉLECTRIQUE

(30) Priorität: 17.12.2013 DE 102013226236
(43) Veröffentlichungstag der Anmeldung: 26.10.2016
(73) Patentinhaber: Robert Bosch GmbH, 70442 Stuttgart (DE)
(72) Erfinder: ZWEIGLE, Peter, 71254 Ditzingen (DE); ZELENY, Franco, 74354 Besigheim (DE)
(86) Internationale Anmeldenummer: PCT/EP2014/073895
(87) Internationale Veröffentlichungsnummer: WO 2015/090718

(56) Entgegenhaltungen:
- EP-A1- 0 591 631
- EP-A1- 0 999 601
- WO-A1-93/12636
- DE-A1- 19 912 834
- FR-A1- 2 605 145
- US-A1- 2008 057 773
- US-A1- 2013 000 972

## Beschreibung

Die Erfindung betrifft eine elektrische Baugruppe mit den Merkmalen des Oberbegriffs des Anspruchs 1.

In der Kraftfahrzeugtechnik werden zur Getriebeansteuerung elektronische Steuermodule verwandt, die am Getriebe und im Getriebefluid angeordnet werden können. Die Steuermodule können beispielsweise elektrische Bauelemente wie Stecker, Sensoren, Aktuatoren, wenigsten ein gekapseltes Steuergerät (TCU, Transmission Control Unit) und gegebenenfalls weitere Komponenten aufweisen, die an einem zentralen Träger befestigt sind und dem Getriebefluid ausgesetzt sind. Die Anordnung im Getriebefluid stellt hohe Anforderungen an die Aufbau- und Verbindungstechnik der Baukomponenten auf dem Träger des elektronischen Steuermoduls, da die elektrischen Verbindungen hohen Temperaturwechselbelastungen sowie dem Getriebefluid mit darin im ungünstigen Fall enthaltenen Metallspänen wiederstehen können müssen. Als Träger der elektrischen Verbindungstechnik werden im Stand der Technik umspritzte Stanzgitter sowie starre Leiterplatten oder flexible Leiterplatten (sogenannte Flexfolien, FPC) eingesetzt.

Umspritzte Stanzgitter, die mit einem aus Spritzguss hergestellten Isolierteil umhüllte metallische Leiter aufweisen, stellen dabei eine besonders robuste und bewähre Lösung dar. Freie Leiterenden der Leiter, die von der Isolierung mit Spritzgussmasse ausgenommen sind, werden mit Steckern, Sensoren, Aktuatoren oder andern elektrischen Bauteilen des Steuermoduls elektrisch kontaktiert. Diese elektrischen Bauteile weisen ein eigenes Komponenten-Isolierteil auf, beispielsweise ein Sensorgehäuse, und sind mit eigenen elektrischen Leitern versehen. Die freien Leiterenden dieser Leiter stehen in Form von Anschlusskontakten aus dem Komponenten-Isolierteil hervor und werden mit den freien Leiterenden der elektrischen Leiter des umspritzten Stanzgitters durch Schweißen oder Löten elektrisch kontaktiert.

Das Dokument US2008/0057773 A1 offenbart eine elektrische Baugruppe nach dem Oberbegriffes des Hauptanspruchs 1.

Die Kontaktstelle muss gegen im Getriebeöl enthaltene aggressive Substanzen und Metallspäne geschützt werden. Bekannt ist die Kontaktstelle in einem an dem umspritzten Stanzgitter ausgebildeten Aufnahmeraum anzuordnen, der nach der Herstellung des elektrischen Kontaktes, also beispielweise der Verschweißung der freien Leiterenden, mit einer Vergussmasse gefüllt wird. Die Vergussmasse wird dabei in den Aufnahmeraum durch eine offene Seite eingefüllt und beispielsweise ausgehärtet. Damit die Vergussmasse vor dem Härten nicht ausläuft, ist der Aufnahmeraum als wannenförmige Vertiefung an wenigstens fünf Seiten geschlossen ausgebildet. Die Vorsehung eines derartigen wannenförmigen Aufnahmeraumes in dem umspritzten Stanzgitterteil beansprucht relativ viel Bauraum, so dass der Träger des elektronischen Steuermoduls eine gewisse Dicke aufweist, was aufgrund der höheren Materialkosten und der Einbausituation am Getriebe nachteilig ist.

### Offenbarung der Erfindung

Es wird vorgeschlagen, dass der Aufnahmeraum eine Innenwandung aufweist, die durch Wandflächen sowohl des ersten Isolierteils als auch eines zweiten Isolierteils gebildet ist. Das erste Isolierteil kann beispielsweise die Spritzgussisolierung eines Stanzgitterteils eines Trägers der Aufbau- und Verbindungstechnik eines elektronischen Steuermoduls sein. Das zweite Isolierteil kann beispielsweise ein Sensorgehäuse, Steckergehäuse oder das Gehäuse einer anderen elektrischen Komponente (beispielsweise eines Aktuators) sein und elektrische Anschlussleiter aufweisen, deren freie Leiterenden mit den Leitern des umspritzten Stanzgitterteils kontaktiert sind. Das erste Isolierteil weist einen Rahmen auf, wobei der Rahmen eine den Aufnahmeraum seitlich begrenzende umlaufende Wandfläche ausbildet und derart auf dem zweiten Isolierteil angeordnet ist, dass eine Wandfläche des zweiten Isolierteils einen den Rahmen einseitig verschließenden Boden des Aufnahmeraumes bildet. Das erste Isolierteil kann vorteilhaft relativ flach ausgelegt werden, da der Boden des Aufnahmeraumes der Vergussmasse durch ein zweites Isolierteil, beispielsweise ein Sensorgehäuse, gebildet wird.

### Vorteile der Erfindung

Durch die erfindungsgemäße Lösung entsteht der Aufnahmeraum für die Vergussmasse erst bei der Anordnung des ersten Isolierteils an dem zweiten Isolierteil. Der Aufnahmeraum ist dabei an wenigstens fünf Seiten dicht verschlossen, so dass kein Auslaufen der Vergussmasse möglich ist. Da die Innenwandung des Aufnahmeraumes durch Wandflächen sowohl des ersten Isolierteils als auch des zweiten Isolierteils gebildet ist, kann der Bauraum der zur Anordnung des Aufnahmeraumes in jedem der beiden elektrischen Bauteile vorgesehen werden muss, vorteilhaft relativ klein gehalten werden. Insbesondere ist es möglich, die auf dem ersten elektrischen Bauteil (beispielsweise einem umspritzten Stanzgitter) benötigte Bauhöhe zu verkleinern, da nur einige und nicht alle Wandflächen des Aufnahmeraumes in das umspritzte Stanzgitter integriert werden. Bei der Herstellung der elektrischen Baugruppe ist die Handhabung erleichtert und die Kontaktstelle zwischen den zu verbindenden elektrischen Leitern besser zugänglich.

Vorteilhafte Ausgestaltungen und Weiterbildungen der Erfindung werden durch die in den abhängigen Ansprüchen enthaltenen Merkmale ermöglicht.

Das erste Isolierteil kann einteilig aufgebaut sein. Es ist aber vorteilhaft auch möglich, dass das erste Isolierteil mehrteilig ausgebildet ist und wenigstens ein Rahmenteil sowie wenigstens ein Trägerteil umfasst, an dem das Rahmenteil festgelegt ist. Das Rahmenteil kann beispielsweise einen Teil oder die gesamte den Aufnahmeraum seitlich begrenzende Wandfläche ausbilden. Das Rahmenteil kann vorteilhaft separat von dem Trägerteil gefertigt werden und mit dem Trägerteil anschließend dicht verbunden werden, so dass ein Verbund entsteht, der das erste Isolierteil darstellt und der einen vollständigen Rahmen aufweist. Der Fertigung des ersten Isolierteils wird dadurch erleichtert, da beispielsweise keine komplizierten Formen im Spritzgusswerkzeug hergestellt werden müssen, sondern sowohl das Rahmenteil als auch das Trägerteil jeweils einen recht einfachen Aufbau aufweisen können.

Vorteilhaft kann das freie Leiterende des zweiten Leiters senkrecht aus dem Boden in den Aufnahmeraum hervorstehen oder das freie Leiterende des ersten Leiters senkrecht von der umlaufenden Wandfläche in den Aufnahmeraum abstehen. Dies erleichtert die Herstellung einer elektrischen Kontaktstelle zwischen den freien Leiterenden, was beispielsweise durch Schweißen erfolgen kann. Vorteilhaft kann das freie Leiterende des ersten Leiters an seinem äußersten Abschnitt parallel zu dem freien Leiterende des zweiten Leiters umgebogen und mit diesem unter Ausbildung der Kontaktstelle beispielsweise verschweißt sein.

Zur Herstellung eines an fünf Seiten abgedichteten Aufnahmeraumes ist es vorteilahft, wenn das erste Isolierteil einen Rahmen aufweist, der unter Zwischenlage eines Dichtmaterials auf dem zweiten Isolierteil angeordnet ist. Das Dichtmaterial kann beispielsweise eine umlaufende Dichtung ausbilden. Die Dichtung kann beispielsweise durch einen Elastomerring (O-Ring) oder eine an das erste Isolierteil oder das zweite Isolierteil im Auflagebereich des ersten Isolierteils und des zweiten Isolierteils angespritzte Elastomerdichtung dargestellt werden. Ein weiteres Ausführungsbeispiel sieht vor, dass die Dichtung durch einen weiteren Verguss mit einem Dichtmaterial gebildet wird, das als umlaufende Dichtung in eine Ausnehmung eingebracht ist, die an einer den Boden des Aufnahmeraumes bildenden Wandfläche des zweiten Isolierteils oder an einer dem zweiten Isolierteil zugewandten Stirnseite des Rahmens ausgebildet ist.

### Kurze Beschreibung der Zeichnungen

Es zeigen:
- Fig. 1: ein erstes Ausführungsbeispiel der Erfindung,
- Fig. 2: ein zweites Ausführungsbeispiel der Erfindung,
- Fig. 3: ein drittes Ausführungsbeispiel der Erfindung,
- Fig. 4: ein viertes Ausführungsbeispiel der Erfindung,
- Fig. 5: ein fünftes Ausführungsbeispiel der Erfindung,
- und Fig. 6: ein sechstes Ausführungsbeispiel der Erfindung.

### Ausführungsformen der Erfindung

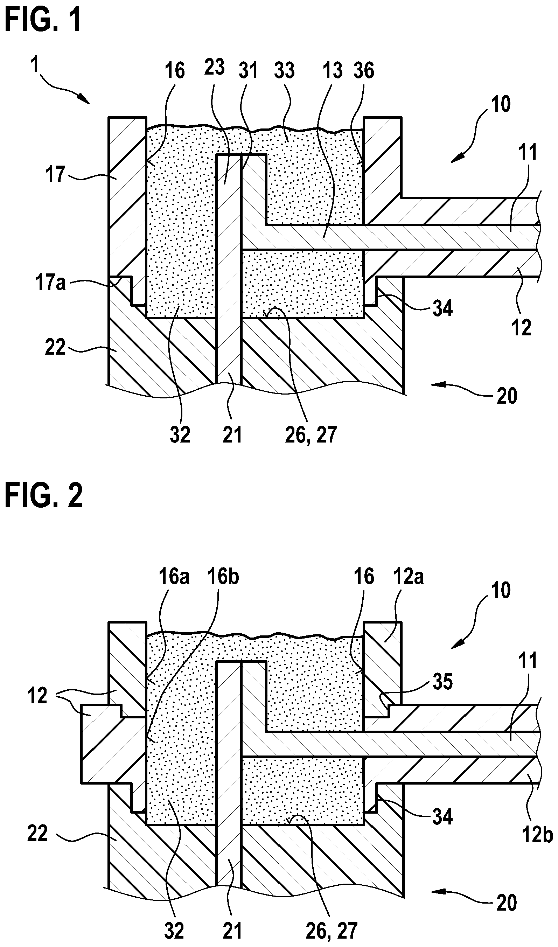

Fig.1 zeigt einen Ausschnitt aus einer elektrischen Baugruppe 1 im Querschnitt. Bei der elektrischen Baugruppe kann es sich beispielsweise um elektrisches oder elektronisches Steuergerät oder Steuermodul einer Getriebesteuerung handeln. Die elektrische Baugruppe weist ein erstes elektrisches Bauteil 10 auf, bei dem es sich beispielsweise um ein umspritztes Stanzgitterteil handelt. Das Stanzgitterteil weist mehrere streifenförmige metallische Leiter auf, die mit einer ein erstes Isolierteil 12 bildenden Isoliermasse umspritzt sind. In dem Ausschnitt der Fig. 1 ist ein erster Leiter 11 dargestellt, der in einem ersten Isolierteil 12 angeordnet ist. Im Kontext der vorliegenden Anmeldung wird unter einem Leiter ein elektrischer Leiter verstanden. Wie in Fig. 1 gut zu erkennen ist, weist das erste Isolierteil 12 einen einstückig an dem Isolierteil ausgebildeten Rahmen 17 auf, der eine umlaufende Wandfläche 16 ausbildet, die einen Aufnahmeraum 32 für die Aufnahme einer Vergussmasse 33 seitlich begrenzt. Die Wandfläche 16 kann im Querschnitt rechteckförmig, kreisrund oder anders ausgebildet sein. Der Rahmen 17 weist zwei sich gegenüberliegende Öffnungen auf, von denen eine mit dem zweiten Isoliersteil 22 verschlossen ist und die andere zur Einfüllung von Vergussmasse 33 dient. Ein freies Leiterende 13 des ersten Leiters 11 steht von der umlaufenden Wandfläche 16 des Rahmens 17 senkrecht in den Aufnahmeraum 32 ab. An seinem äußersten Abschnitt ist das erste Leiterende 13 beispielsweise senkrecht umgebogen.

Unabhängig von dem ersten elektrischen Bauteil 10 ist ein zweites elektrisches Bauteil 20 hergestellt. Das zweite elektrische Bauteil 20 ist beispielsweise ein Sensor, Stecker oder Aktuator. Auch das zweite elektrische Bauteil 20 kann ein umspritztes Stanzgitterteil sein. Von dem zweiten elektrischen Bauteil 20 ist in Fig. 1 nur der elektrische Anschlussabschnitt dargestellt. Das zweite elektrische Bauteil 20 kann mehrere elektrische Leiter aufweisen, von denen in Fig. 1 nur ein zweiter Leiter 21 erkennbar ist. Der zweite Leiter 21 ist in ein zweites Isolierteil 22 eingebettet und an seinem nicht dargestellten Leiterende mit einem Sensorelement elektrisch verbunden. Das andere freie Leiterende 23 des Leiters 21 steht senkrecht von einer Wandfläche 26 in den Aufnahmeraum 32 ab.

Das erste elektrische Bauteil 10 und das zweite elektrische Bauteil 20 sind mechanisch miteinander verbunden. Dies geschieht beispielsweise, indem das erste Isolierteil 12 mit dem Rahmen 17 auf das zweite Isolierteil 22 des zweiten elektrischen Bauteils 20 aufgesetzt wird. Dabei gelangt eine Stirnseite 17a des Rahmens 17 an dem zweiten Isolierteil 22 im Bereich des Bezugszeichens 34 zur Anlage. Dies kann beispielsweis durch eine Presspassung im Bereich des Bezugszeichens 34 erfolgen. Der Rahmen 17 kann an seiner Stirnseite 17a eine Abstufung aufweisen, die in einen komplementär konturierten Kragen des zweiten Isolierteils 22 unter Ausbildung eines Dichtlabyrinths eingreift. An dieser Stelle kann der Kunststoff auch aufgeschmolzen werden, um eine Dichtung zu erzielen.

Der Verbund aus dem ersten elektrischen Bauteil 10 und dem zweiten elektrischen Bauteil 20 bildet einen Aufnahmeraum 32, der an wenigstens fünf Seiten und vorzugsweise an genau fünf Seiten geschlossen ausgebildet ist. Dabei werden vier Seiten durch die umlaufende Wandfläche 16 des Rahmens 17 des ersten Isolierteils 12 und die fünfte Seite durch eine Wandfläche 26 des zweiten Isolierteils 22 gebildet, die gleichzeitig den Boden 27 des Aufnahmeraumes 32 darstellt. Der Aufnahmeraum 32 weist daher eine an fünf Seiten geschlossene Innenwandung 36 auf, die mit einer Vergussmasse 33 gefüllt ist. Beim Einfüllen der Vergussmasse 33 wird diese durch die offene Oberseite des Rahmens 17 eingefüllt und beispielsweise anschließend ausgehärtet. In Fig. 1 ist zu erkennen, dass das freie Leiterende 13 des ersten Leiters 11 an seinem äußersten Abschnitt parallel zu dem freien Leiterende 23 des zweiten Leiters 21 umgebogen ist und mit diesem unter Ausbildung der Kontaktstelle 31 beispielsweise durch Verschweißen elektrisch verbunden. Die Vergussmasse 33 bedeckt die Kontaktstelle 31 und die freien Leiterenden 13 und 23 des ersten Leiters 11 und des zweiten Leiters 21.

Ein zweites Ausführungsbeispiel ist in Fig. 2 dargestellt. Dieses Ausführungsbeispiel unterscheidet sich von dem ersten Ausführungsbeispiel dadurch, dass das erste Isolierteil 12 zweiteilig ausgebildet ist und ein Trägerteil 12b und ein daran angeordnetes Rahmenteil 12a aufweist. Das Trägerteil 12b ist hier besonders flach ausgebildet und weist einen Wandabschnitt 16b auf, der zusammen mit einem Wandabschnitt 16a des Rahmenteils 12a die umlaufende Wandfläche 16 des Aufnahmeraumes 32 ausbildet. Das Rahmenteil 12 kann im Bereich des Bezugszeichens 35 durch eine Presspassung an dem Trägerteil 12b festgelegt werden. Die Dichtung im Bereich des Bezugszeichens 35 kann hier ähnlich zu der bereits oben erläuterten Dichtung zwischen dem ersten Isolierteil 12 und dem zweiten Isolierteil 22 im Bereich des Bezugszeichens 34 erfolgen, also beispielsweise mit einer Stufe oder Dichtlippe versehen sein und durch Presspassen oder Aufschmelzen oder ähnliche Verfahren abgedichtet sein.

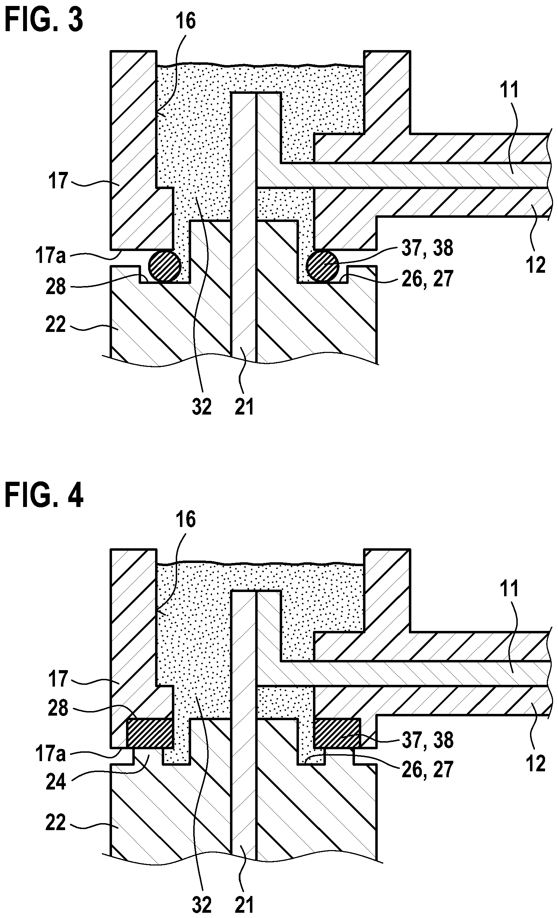

Fig. 3 zeigt ein drittes Ausführungsbeispiel. Bei diesem Ausführungsbeispiel ist das erste Isolierteil 12 wieder einteilig ausgebildet. Der an dem ersten Isolierteil 11 ausgebildete Rahmen 17 weist eine dem zweiten Isolierteil 22 zugewandte Stirnseite 17a auf, die unter Zwischenlage einer Dichtung 38 aus beispielsweise einem Elastomermaterial als Dichtmaterial 37 auf die Wandfläche 26 des zweiten Isolierteils 22 aufgesetzt ist. Die Dichtung kann beispielsweise durch einen O-Ring gebildet werden, der in eine Ausnehmung 28 in der Wandfläche 26 oder in der Stirnseite 17a (nicht dargestellt) eingelegt ist. Die Ausnehmung 28 kann als umlaufende Nut ausgebildet sein.

Bei einem weiteren in Fig. 4 dargestellten Ausführungsbeispiel ist der Rahmen 17 an seiner dem zweiten Isolierteil 22 zugewandten Seite mit einer Ausnehmung 28 versehen, in die eine umlaufende Dichtung 38 aus einem Dichtmaterial 37, beispielsweise ein Elastomer, angespritzt ist. Das Dichtmaterial wurde also auf die Stirnseite 17a im Bereich der Ausnehmung 28 aufgespritzt. Die Wandfläche 26 des zweiten Isolierteils 22 weist einen Kragen 24 auf, der gegen die Dichtung 38 angepresst wird.

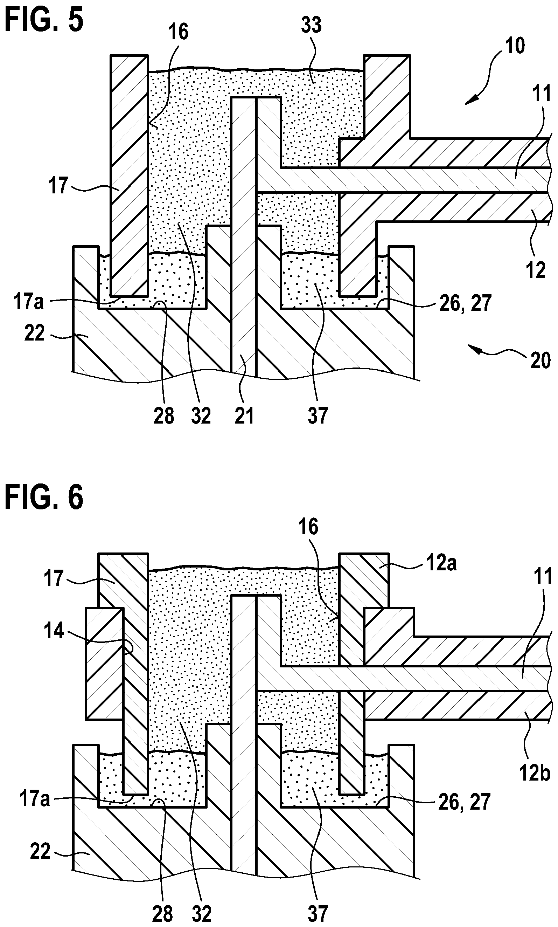

Ein weiteres Ausführungsbeispiel zeigt Fig. 5. Bei diesem Ausführungsbeispiel ist das erste Isolierteil 11 wieder einstückig ausgebildet und weist einen einteilig damit ausgebildeten Rahmen 17 auf. Das zweite Isolierteil 12 ist an seiner dem ersten Isolierteil 11 zugewandten Seite mit einer umlaufenden Ausnehmung 28 versehen, die beispielsweise eine Ringnut bildet. Die Ausnehmung 28 ist mit einem Dichtmaterial 37 aufgefüllt. Das Dichtmaterial 37 kann aus dem gleichen Material bestehen, wie die den Aufnahmeraum 32 füllende Vergussmasse 33. Der Rahmen 17 ist mit seiner umlaufenden Stirnseite 17a in das Dichtmaterial 37 eingetaucht. Dies geschieht zweckmäßiger Weise bevor die Vergussmasse 33 eingefüllt wird und nachdem die freien Leiterenden 13, 23 miteinander verschweißt wurden. Auch hier entsteht ein an fünf Seiten abgedichteter Aufnahmeraum 32, dessen Innenwandung durch die umlaufende Wandfläche 16 des Rahmens 17 und durch die den Boden 27 bildende und teilweise mit dem Dichtmaterial 37 bedeckte Wandfläche 26 des zweiten Isolierteils 22 gebildet wird.

Fig. 6 zeigt ein weiteres Ausführungsbeispiel. Bei diesem Ausführungsbeispiel ist das erste Isolierteil 12 wieder zweiteilig mit einem Trägerteil 12b und einem Rahmenteil 12a ausgebildet. Im Unterschied zu Fig. 2 bildet hier das Rahmenteil 12a die gesamte umlaufende Wandung 16 des Aufnahmeraumes 32. Das Rahmenteils 12a ist hülsenförmig aus Isolierstoff ausgebildet, wobei der erste Leiter 11 durch die Wand des Rahmenteils 12a dicht hindurchgeführt ist. Das Trägerteil 12b weist eine Öffnung 14 auf, durch die sich das hülsenförmige Rahmenteil 12a hindurch erstreckt. Ähnlich wie in Fig. 5 bildet das Rahmenteil 12a einen Rahmen 17, dessen Stirnseite 17a in Dichtmaterial 37 eintaucht, das in einer umlaufenden Ausnehmung 28 der Wandfläche 27 des zweiten Isolierteils 22 angeordnet ist.

Es versteht sich, dass weitere Ausführungsbeispiele möglich sind, welche sich als Kombinationen der dargestellten Ausführungsformen ergeben. Außerdem sind Abwandlungen möglich. Beispielsweise kann das erste Isolierteil drei oder mehr Teile aufweisen oder das zweite Isolierteil mehrteilig ausgeführt sein. Ebenso sind Ausführungsbeispiele mit anders abgebogenen Leiterenden möglich. Es ist auch möglich, mehrere Leiterenden von mehreren ersten Leitern und mehreren zweiten Leitern gemeinsam in einem Aufnahmeraum anzuordnen und dort jeweils paarweise zu kontaktieren. Die elektrische Kontaktstelle zwischen den Leiterenden kann auch durch Löten, Leitkleben, Schweißen, Laserschweißen, Schneidklemmverbindung oder in anderer Weise hergestellt sein. Die Erfindung ist nicht auf die Verwendung in elektrischen Steuermodulen für die Getriebesteuerung beschränkt und kann auch in anderen elektrischen Baugruppen eingesetzt werden.

## Patentansprüche

1. Elektrische Baugruppe mit einem ersten elektrischen Bauteil (10), das wenigstens einen ersten Leiter (11) umfasst, der in einem erstes Isolierteil (12) angeordnet ist und wenigstens ein freies Leiterende (13) aufweist, das aus dem ersten Isolierteil (12) hervorsteht, und mit einem unabhängig von dem ersten elektrischen Bauteil (10) hergestellten zweiten elektrischen Bauteil (20), das wenigstens einen zweiten Leiter (21) umfasst, der in einem zweiten Isolierteil (22) angeordnet ist und wenigstens ein freies Leiterende (23) aufweist, das aus dem zweiten Isolierteil (22) hervorsteht, und mit einem an der elektrischen Baugruppe (1) ausgebildeten Aufnahmeraum (32), in dem eine elektrische Kontaktstelle (31) zwischen dem ersten Leiter (13) und dem zweiten Leiter (23) angeordnet ist, wobei der Aufnahmeraum (32) wenigstens teilweise mit einer Vergussmasse (33) derart gefüllt ist, dass die Kontaktstelle (31) und die freien Leiterenden (13, 23) des ersten Leiters (11) und des zweiten Leiters (21) von der Vergussmasse (33) bedeckt sind und die Vergussmasse (33) durch eine Innenwandung (36) des Aufnahmeraumes (32) an wenigstens fünf Seiten begrenzt ist, wobei die Innenwandung (36) des Aufnahmeraumes (32) durch Wandflächen (16, 26) sowohl des ersten Isolierteils (12) als auch des zweiten Isolierteils (22) gebildet ist, wobei das erste elektrische Bauteil (10) durch ein metallisches Stanzgitterteil gebildet ist, das mit einer das erste Isolierteil (12) bildenden Spritzgussmasse wenigsten abschnittsweise umhüllt ist und dass das zweite elektrische Bauteil (20) durch ein metallisches Stanzgitterteil gebildet ist, das mit einer das zweite Isolierteil (22) bildenden Spritzgussmasse wenigsten abschnittsweise umhüllt ist, **dadurch gekennzeichnet, dass** das erste Isolierteil (12) einen Rahmen (17) aufweist, der eine den Aufnahmeraum (32) seitlich begrenzende umlaufende Wandfläche (16) ausbildet und derart auf dem zweiten Isolierteil (22) angeordnet ist, dass eine Wandfläche (26) des zweiten Isolierteils (22) einen den Rahmen (17) einseitig verschließenden Boden (27) des Aufnahmeraumes (32) bildet.

2. Elektrische Baugruppe nach Anspruch 1, **dadurch gekennzeichnet, dass** das erste Isolierteil (12) mehrteilig aufgebaut ist und wenigsten ein Trägerteil (12b) sowie wenigstens ein Rahmenteil (12a) umfasst, das an dem das Trägerteil (12b) festgelegt ist.

3. Elektrische Baugruppe nach Anspruch 1, **dadurch gekennzeichnet, dass** das freie Leiterende (23) des zweiten Leiters (21) senkrecht aus dem Boden (27) in den Aufnahmeraum (32) hervorsteht.

4. Elektrische Baugruppe nach Anspruch 1, **dadurch gekennzeichnet, dass** das freie Leiterende (13) des ersten Leiters (11) von der umlaufenden Wandfläche (16) in den Aufnahmeraum (32) absteht.

5. Elektrische Baugruppe nach Anspruch 3 und 4, **dadurch gekennzeichnet, dass** das freie Leiterende (13) des ersten Leiters (11) an seinem äußersten Abschnitt parallel zu dem freien Leiterende (23) des zweiten Leiters (21) umgebogen ist und mit diesem unter Ausbildung der Kontaktstelle (31) elektrisch verbunden, insbesondere verschweißt ist.

6. Elektrische Baugruppe nach Anspruch 1, **dadurch gekennzeichnet, dass** der Rahmen (17) unter Zwischenlage eines Dichtmaterials (37) auf dem zweiten Isolierteil (22) angeordnet ist.

7. Elektrische Baugruppe nach Anspruch 6, **dadurch gekennzeichnet, dass** das Dichtmaterial (37) eine umlaufende Dichtung ausbildet.

8. Elektrische Baugruppe nach Anspruch 7, **dadurch gekennzeichnet, dass** die umlaufende Dichtung in eine Ausnehmung (28) eingebracht ist, die an dem Boden (27) oder an einer dem zweiten Isolierteil (22) zugewandten Stirnseite (17a) des Rahmens (17) ausgebildet ist.

## Claims

1. Electrical assembly having a first electrical component (10) that comprises at least one first conductor (11) that is arranged in a first insulating part (12) and comprises at least one free conductor end (13) that protrudes from the first insulating part (12), and said electrical assembly having a second electrical component (20) that is produced independently from the first electrical component (10) and comprises at least one second conductor (21) that is arranged in a second insulating part (22) and said second conductor comprises at least one free conductor end (23) that protrudes out of the second insulating part (22), and said electrical assembly having a receiving chamber (32) that is embodied on the electrical assembly (1) and an electrical contact site (31) is arranged in said receiving chamber between the first conductor (13) and the second conductor (23), wherein the receiving chamber (32) is filled at least in part with a potting compound (33) in such a manner that the contact site (31) and the free conductor ends (13, 23) of the first conductor (11) and of the second conductor (21) are covered by the potting compound (33) and the potting compound (33) is delimited on at least five sides by means of an inner wall (36) of the receiving chamber (32), wherein the inner wall (36) of the receiving chamber (32) is formed by wall surfaces (16, 26) both of the first insulating part (12) and also of the second insulating part (22), wherein the first electrical component (10) is formed by means of a metal lead frame part that is encased at least in sections by an injection molding compound that forms the first insulating part (12) and that the second electrical component (20) is formed by means of a metal lead frame part that is encased at least in sections by an injection molding compound that forms the second insulating part (22), **characterized in that** the first insulating part (12) comprises a frame (17) that forms a circumferential wall surface (16) that delimits the receiving chamber (32) at the sides and is arranged on the second insulating part (22) in such a manner that a wall surface (26) of the second insulating part (22) forms a base (27) of the receiving chamber (32) that seals the frame (17) on one side.

2. Electrical assembly according to Claim 1, **characterized in that** the first insulating part (12) is constructed as a multi-piece and comprises at least one carrier part (12b) and at least one frame part (12a) that is fixed to the the carrier part (12b).

3. Electrical assembly according to Claim 1, **characterized in that** the free conductor end (23) of the second conductor (21) protrudes in a perpendicular manner out of the base (27) into the receiving chamber (32).

4. Electrical assembly according to Claim 1, **characterized in that** the free conductor end (13) of the first conductor (11) protrudes from the circumferential wall surface (16) into the receiving chamber (32).

5. Electrical assembly according to Claim 3 and 4, **characterized in that** the free conductor end (13) of the first conductor (11) is bent at its outermost section parallel to the free conductor end (23) of the second conductor (21) and is electrically connected thereto, in particularly welded, to form the contact site (31).

6. Electrical assembly according to Claim 1, **characterized in that** the frame (17) is arranged on the second insulating part (22) by means of interpositioning a sealing material (37).

7. Electrical assembly according to Claim 6, **characterized in that** the sealing material (37) forms a circumferential seal.

8. Electrical assembly according to Claim 7, **characterized in that** the circumferential seal is introduced into a recess (28) that is formed at the base (27) or at an end face (17a) of the frame (17), said end face facing the second insulating part (22).

## Revendications

1. Sous-ensemble électrique comprenant un premier composant électrique (10), qui comporte au moins un premier conducteur (11) disposé dans une première partie isolante (12) et possédant au moins une extrémité de conducteur libre (13) qui dépasse de la première partie isolante (12), et un deuxième composant électrique (20), fabriqué indépendamment du premier composant électrique (10), qui comprend au moins un deuxième conducteur (21) disposé dans une deuxième partie isolante (22) et possédant au moins une extrémité de conducteur libre (23) qui dépasse de la deuxième partie isolante (22), et un espace de réception (32), formé sur le sous-ensemble électrique (1), dans lequel un point de contact électrique (31) est disposé entre le premier conducteur (13) et le deuxième conducteur (23), l'espace de réception (32) étant rempli au moins en partie d'une masse de coulée (33) de telle manière que le point de contact (31) et les extrémités de conducteurs libres (13, 23) du premier conducteur (11) et du deuxième conducteur (21) soient recouverts par la masse de coulée (33), la masse de coulée (33) étant délimitée sur au moins cinq côtés par une paroi intérieure (36) de l'espace de réception (32), la paroi intérieure (36) de l'espace de réception (32) étant formée par des surfaces de parois (16, 26) de la première partie isolante (12) ainsi que de la deuxième partie isolante (22), le premier composant électrique (10) étant formé par une partie formant grille d'emboutissage métallique qui est enveloppée au moins par sections par une masse de moulage par injection formant la première partie isolante (12) et que le deuxième composant électrique (20) est formé par une partie formant grille d'emboutissage métallique qui est enveloppée au moins par sections par un masse de moulage par injection formant la deuxième partie isolante (22), **caractérisé en ce que** la première partie isolante (12) comporte un châssis (17) qui forme une surface de paroi circonférentielle (16) délimitant latéralement l'espace de réception (32) et est disposée sur la deuxième partie isolante (22) de telle manière qu'une surface de paroi (26) de la deuxième partie isolante (22) forme un fond (27) de l'espace de réception (32) qui ferme d'un côté le châssis (17).

2. Sous-ensemble électrique selon la revendication 1, **caractérisé en ce que** la première partie isolante (12) est réalisée en plusieurs parties et comprend au moins une partie porteuse (12b) et au moins une partie formant châssis (12a) qui est fixée à la la partie porteuse (12b).

3. Sous-ensemble électrique selon la revendication 1, **caractérisé en ce que** l'extrémité de conducteur libre (23) du deuxième conducteur (21) dépasse verticalement du fond (27) dans l'espace de réception (32).

4. Sous-ensemble électrique selon la revendication 1, **caractérisé en ce que** l'extrémité de conducteur libre (13) du premier conducteur (11) dépasse de la surface de paroi circonférentielle (16) dans l'espace de réception (32).

5. Sous-ensemble électrique selon les revendications 3 et 4, **caractérisé en ce que** l'extrémité de conducteur libre (13) du premier conducteur (11) est repliée sur sa partie la plus extérieure parallèlement à l'extrémité de conducteur libre (23) du deuxième conducteur (21) et y est reliée électriquement, en particulier par soudage, en formant le point de contact (31) .

6. Sous-ensemble électrique selon la revendication 1, **caractérisé en ce que** le châssis (17) est disposé sur la deuxième partie isolante (22) avec interposition d'un matériau d'étanchéité (37).

7. Sous-ensemble électrique selon la revendication 6, **caractérisé en ce que** le matériau d'étanchéité (37) forme un joint circonférentiel.

8. Sous-ensemble électrique selon la revendication 7, **caractérisé en ce que** le joint circonférentiel est introduit dans un évidement (28) qui est réalisé sur le fond (27) ou sur une face frontale (17a) du châssis (17) qui est tournée vers la deuxième partie isolante (22).
